(19) Europäisches Patentamt
European Patent Office
Office européen des brevets

(11) **EP 2 166 562 B1**

(12) **EUROPEAN PATENT SPECIFICATION**

(45) Date of publication and mention
of the grant of the patent:
**20.03.2019 Bulletin 2019/12**

(21) Application number: **09075435.9**

(22) Date of filing: **22.09.2009**

(51) Int Cl.:
*H01L 21/02* (2006.01)   *H01L 21/8242* (2006.01)
*C23C 16/40* (2006.01)   *H01L 21/314* (2006.01)
*H01L 21/316* (2006.01)   *C23C 16/455* (2006.01)
*H01L 27/108* (2006.01)   *H01L 49/02* (2006.01)
*H01L 27/11507* (2017.01)

(54) **Method for forming a capacitor having a strontium titanium oxide dielectric layer by means of ALD**

ALD-Herstellungsverfahren für einen Kondensator mit einer dielektrischen Schicht auf Strontium-Titanoxid-Basis

Procédé de formation par ALD d'un condensateur doté d'une couche diélectrique à base de dioxyde de titane de strontium

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **22.09.2008 US 99001 P**

(43) Date of publication of application:
**24.03.2010 Bulletin 2010/12**

(73) Proprietor: **IMEC VZW**
**3001 Leuven (BE)**

(72) Inventors:
• **Kittl, Jorge**
**1410 Waterloo (BE)**
• **Popovici, Mihaela Ioana**
**3000 Leuven (BE)**
• **Menou, Nicolas**
**2260 Westerlo (BE)**
• **Wouters, Dirk**
**3001 Leuven (BE)**

(56) References cited:
WO-A1-02/41371       US-A1- 2006 105 521
US-A1- 2006 214 205

• HAENI J H ET AL: "Epitaxial growth of the first five members of the Srn+1TinO3n+1 Ruddlesden-Popper homologous series" APPLIED PHYSICS LETTERS, AIP, AMERICAN INSTITUTE OF PHYSICS, MELVILLE, NY, US LNKD- DOI:10.1063/1.1371788, vol. 78, no. 21, 21 May 2001 (2001-05-21), pages 3292-3294, XP012028108 ISSN: 0003-6951

## Description

### Field of the disclosure

The present disclosure relates to capacitive structures whereby an insulating material is sandwiched between a metal top electrode and a metal bottom electrode. These capacitive structures are also known as MIM (metal-insulator-metal) capacitive structures. In particular the present disclosure relates to volatile memory cells comprising such MIM capacitive structures.

### Background

Future dynamic random access memory (DRAM) nodes require Metal-Insulator-Metal capacitors (MIMcaps) having Equivalent Oxide Thicknesses (EOT) less than 0.5 nm and low leakage current densities, i.e. less than $10^{-7}$ A/cm$^2$.

Typical high dielectric constant (K) materials, such as $ZrO_2/Al_2O_3/ZrO_2$, used nowadays in fabrication lines are no longer considered as potential solutions for future DRAM nodes because of their too low dielectric constant ~(K40).

Hence, various materials systems are being explored to manufacture such MIM capacitors, in particular for use in a DRAM memory cell. Among various materials, $Sr_xTi_yO_3$ (STO) appears as a promising candidate. The interest in this material can be explained both by its good dielectric characteristics (K-150-300) and also by recent improvements in the atomic layer deposition (ALD) process enabling the deposition of conformal STO thin films at a reasonably low processing temperature ($\leq$ 300 °C) suitable for high aspect ratio DRAM applications.

United States patent US 7,108,747 discloses an Atomic Layer Deposition (ALD) process for producing $SrTiO_3$ thin films. United States patent application US2006/0219157 also discloses an Atomic Layer Deposition (ALD) process for producing titanium containing oxide thin films.

Recently, ALD $Sr_xTi_yO_3$ using $Sr(thd)_2$ as the Sr precursor has been reported with promising results on noble like metal electrodes such as Ru and Pt. Oh Seong Kwon et al discloses in "Atomic Layer Deposition and Electrical Properties of $SrTiO_3$ Thin films Grown using Sr $(C_{11}H_{19}O_2)_2$, Ti $(Oi\text{-}C_3H_7)_4$ and $H_2O$" in Journal Of electrochemical Society 154 (6), G127-G133 (2007) a method for growing $SrTiO_3$ (STO) thin films by means of Atomic Layer Deposition (ALD) thereby using particular precursors. The thin dielectric film is grown on a Ru bottom electrode. However, the processes used required either high deposition temperatures (> 350 °C) and/or post-deposition anneals in an oxidizing ambient, making them incompatible with a TiN bottom electrode. Moreover metal such as Ru and Pt are not compatible with state-of-the-art logic semiconductor processing.

In patent application US2006/0214205 a thin-film capacitor is disclosed having a lower electrode comprising TiN, a ferroelectric layer (for example a perovskite oxide such as SrTiO or pyrochlore oxide such as $Sr_2TiO_z$) and an upper electrode that adds a compressive stress to the ferroelectric layer.

The prior art document "Epitaxial growth of the first five members of the Srn+1TinO3n+1 Ruddlesden-Popper homologous series", J. Haeni et al., APPLIED PHYSICS LETTERS, vol. 78, no. 21, 21 May 2001, pages 3292-3294 discloses a way of growing several examples of $Sr_xTi_yO_z$ oxides by reactive molecular beam epitaxy for parallel plate capacitors.

Therefore there is a need to manufacture a metal-insulator-metal capacitor structure having an EOT of 0.5nm or less and a leakage current less than $5\times10^{-7}$ A/cm$^2$.

There is a need to manufacture such capacitor using process steps and materials that are compatible with standard logic semiconductor processing.

There is a need to form such the insulating layer of such capacitor at temperatures equal to or less than 300°C.

There is a need to manufacture such a capacitor having a reduced EOT of the interfacial oxide between the insulating layer and the bottom electrode.

### Summary

According to the invention, a method according to claim 1 is provided.

### Brief description of the drawings

Figure 1 shows a schematic of a MIM capacitor according to the disclosure.
Figure 2 shows a DRAM memory cell containing a transistor and a MIM capacitor according to the disclosure.
Figures 3a-c illustrates, by means of schematic cross-sectional views of process steps, a method for manufacturing MIM capacitor according to the disclosure.

Figure 4 shows a schematic of the pulse sequence of the ALD STO deposition process for manufacturing MIM capacitor according to a first exemplary embodiment.

Figure 5 shows the Sr/Ti atomic ratio x/y, determined by RBS, as function of the Sr/Ti pulse ratio (n*/m*) according to a first exemplary embodiment.

Figure 6 shows high resolution RBS profiles of STO films for the three compositions illustrated by figure 5: standard composition (diamonds), Ti-rich (squares), Sr-rich (triangles), according to a first exemplary embodiment.

Figure 7 shows the perovskite crystallization temperature (°C) as function of the film thickness (nm), for STO films having one of the three compositions illustrated by figure 5, according to a first exemplary embodiment.

Figure 8 shows XRD spectra of STO films, having one of the three compositions illustrated by figure 5, on a ALD TiN bottom electrode: as-deposited (full line), after anneal to 600°C (open circles) and after high temperature anneal (closed circles), according to a first exemplary embodiment.

Figure 9 shows capacitance-voltage (C-V) and conductance-voltage (G-V) curves of STO films having either the crystalline standard composition or crystalline Sr-rich composition as illustrated by figure 5 for two different STO film thicknesses, according to a first exemplary embodiment.

Figure 10 shows the EOT-thickness (nm) as function of the physical thickness (nm) for STO films having the Std. Comp., as illustrated in figure 5, when deposited on a MOCVD TiN bottom electrode after various thermal treatments, according to a first exemplary embodiment.

Figure 11 shows the capacitance (C) (full symbols) and conductance G (open symbols) as function of the capacitor area (um2) for STO films, having one of the three compositions illustrated by figure 5, on an ALD TiN bottom electrode: standard composition (diamonds), Ti-rich (squares), Sr-rich (triangles), according to a first exemplary embodiment.

Figure 12 shows leakage current density (Jg) vs. voltage (V) characteristics for crystallized STO films, having one of the three compositions illustrated by figure 5, on a ALD TiN bottom electrode: standard composition (diamonds), Ti-rich (squares), Sr-rich (triangles), according to a first exemplary embodiment.

Figure 13 shows the EOT thickness as function of the physical thickness for a STO film formed on an ALD TiN bottom electrode, the STO film having either the standard composition or the Sr-rich composition as illustrated by figure 5, according to a first exemplary embodiment.

Figure 14 shows the leakage current density (Jg) vs. voltage (V) characteristic for 8nm crystallized Sr-rich STO film, as illustrated by figure 5, on a ALD TiN bottom electrode: standard composition (diamonds), Ti-rich (squares), Sr-rich (triangles), according to a first exemplary embodiment.

Figure 15 shows the leakage current density (Jg) vs. voltage (V) characteristics for crystallized STO films, having either the standard composition or the Sr-rich composition as illustrated by figure 5, for different types of bottom electrodes: W, ALD TiN, MOCVD TiN and for different thermal treatments, according to a first exemplary embodiment.

Figure 16 shows high resolution RBS profiles of $Sr_xTi_yO_3$ films for the various compositions of the STO film according to a second exemplary embodiment.

Figure 17 shows temperature of crystallization into perovskite $Sr_xTi_yO_3$ phase as a function of STO film composition and thickness according to a second exemplary embodiment. The crystallization temperatures are extracted from IS-XRD measurements.

Figure 18 shows $\theta$-$2\theta$ XRD diagrams of 10 nm $Sr_xTiyO_3$ films deposited on a TiN bottom electrode with various compositions after high temperature anneal according to a second exemplary embodiment.

Figure 22 shows XRD diagrams focused on the (200) Bragg peak of 10 nm Sr-rich (3:1) $Sr_xTi_yO_3$ films as-deposited, after anneal at 600°C and after high temperature anneal according to a second exemplary embodiment. As a comparison, the position of reported cubic $SrTiO_3$ (200) peak is given.

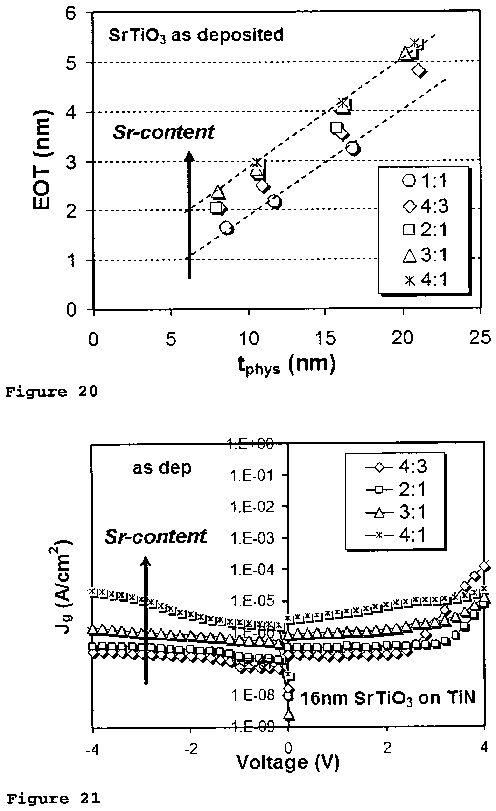

Figure 20 shows the equivalent oxide thickness (EOT) vs. physical thickness of as deposited (amorphous) $Sr_xTi_yO_3$ films with various compositions according to a second exemplary embodiment. The bottom (respectively top) electrode was TiN (respectively Pt).

Figure 21 shows the leakage current density ($J_g$) vs. applied voltage (V) characteristics of 16 nm as deposited (amorphous) $Sr_xTi_yO_3$ films with various compositions according to a second exemplary embodiment. The delay time was 10ms.

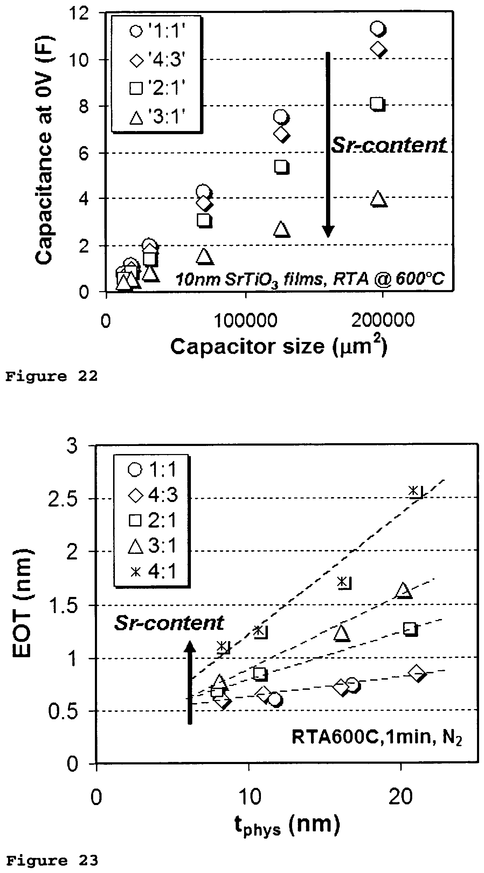

Figure 22 shows the capacitance (measured at 0 V, 1 kHz) vs. capacitor area of 10 nm crystalline $Sr_xTi_yO_3$ films with various compositions according to a second exemplary embodiment. The crystallization anneal was performed at 600°C for 1 min in $N_2$. The bottom (respectively top) electrode was TiN (respectively Pt).

Figure 23 shows the equivalent oxide thickness (EOT) vs. physical thickness of crystalline $Sr_xTi_yO_3$ films with various compositions according to a second exemplary embodiment. The crystallization anneal was performed at 600°C for lmin in $N_2$. The bottom (respectively top) electrode was TiN (respectively Pt).

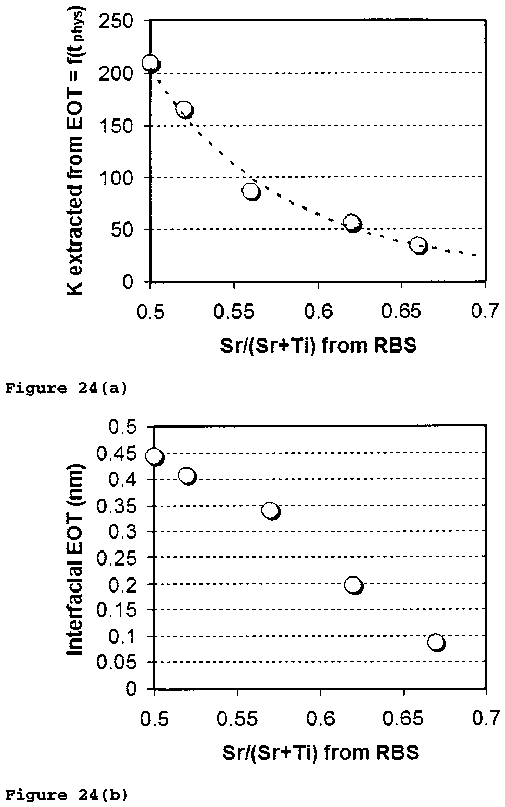

Figure 24 shows the evolution of the dielectric constant (a) and interfacial EOT (b) as a function of the STO film composition according to a second exemplary embodiment. The K and interfacial EOT values are extracted form linear fitting of the EOT vs. physical thickness data presented in figure 23.

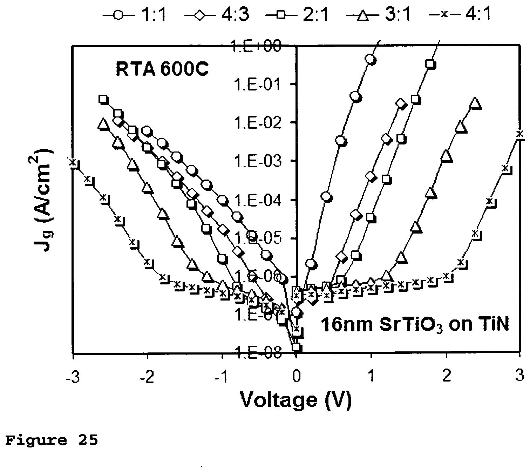

Figure 25 shows leakage current density ($J_g$) vs. applied voltage (V) characteristics of 16 nm crystalline $Sr_xTi_yO_3$ films with various compositions according to a second exemplary embodiment. The delay time was 550ms. The crystallization anneal was performed at 600°C for 1 min in $N_2$. The bottom (respectively top) electrode was TiN (respectively Pt).

## Detailed description

The drawings described are only schematic and are non-limiting. In the drawings, the size of some of the elements may be exaggerated and not drawn on scale for illustrative purposes. The dimensions and the relative dimensions do not necessarily correspond to actual reductions to practice of the disclosure.

Furthermore, the terms first, second, third and the like in the description and in the claims, are used for distinguishing between similar elements and not necessarily for describing a sequential or chronological order. The terms are interchangeable under appropriate circumstances and the embodiments of the disclosure can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the disclosure described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present disclosure, the only relevant components of the device are A and B.

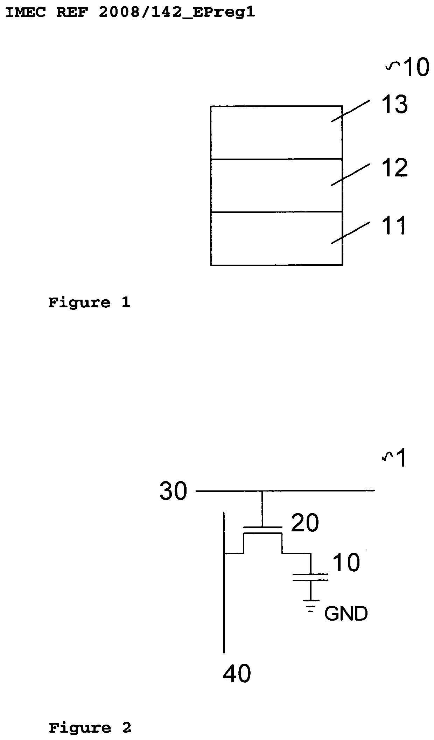

MIM capacitors **10** are formed by sandwiching a layer **12** of insulating material between a metal top electrode **13** and a metal bottom electrode **11** as shown in figure 1. The bottom electrode **11** is the layer in direct physical contact with the insulating layer **12.** Other layers can be present underneath the bottom electrode **11** to provide a good electrical contact to other devices **20** and/or to provide a diffusion barrier. The insulating layer should be formed in a conformal way to provide good step coverage over the underlying bottom electrode **11.** Such capacitors **10** are used inter alia to form dynamic random access memory cells (DRAM). DRAM cells are preferably manufactured using materials, in particular metals, compatible with the processing of logic semiconductor devices such as transistors to allow processing of logic devices and MIM capacitors on the same chip. These materials are available at low-cost and manufacturing-friendly.

An elementary DRAM memory cell **1** consists of a selection element **20,** such as transistor, and capacitor **10** as shown in figure 2. The transistor **20** controls the access to the capacitor **10** as this capacitor **10** is connected between one junction of the transistor **10** and ground **GND.** In such a memory cell information is saved by storing the corresponding amount of charge on the capacitor **10.** Typically these memory cells are arranged in a matrix configuration whereby a word line **30** connects the gate of each transistor **10** in the same row, while a bit line **40** connects the other junction each transistor **10** in the same column.

The material of the insulating layer **12** is selected to have a high value of its relative dielectric constant k and a low leakage current such that information can be temporally stored with limited amount of charge. The high relative dielectric constant k of the insulating layer **12** allows obtaining a thin electrical Equivalent Oxide Thickness (EOT) for a physical thicker layer thereby offering a high capacitance value per unit square. With high-k dielectric is meant a dielectric material having a relative dielectric constant k larger than 1, typically larger than 10.

The metals of the top **13** and bottom **11** electrodes are selected to help reducing the overall series resistance of the memory cell **1.** The process for forming the insulating layer **12** must be compatible with the material used to form the bottom electrode **11.** High thermal budgets used to form the insulating layer **12** either during deposition or during post-deposition anneal steps might impact the physical and electrical properties of the bottom electrode **11.** Also the ambient in which the insulating layer **12** is formed might influence physical and electrical properties of the bottom electrode **11.**

A $Sr_xTi_yO_z$ (STO) based Metal-Insulator-Metal (MIM) capacitor **10** is disclosed having an EOT of less than 0.5nm and a leakage current less $5x10^{-7}$ A/cm$^2$, preferably less than $1x10^{-7}$ A/cm$^2$, when 1V is applied between the top **13** and bottom **11** electrode. X, y and z are integers, whereby z is preferably 3 and x/y>1.

The as-deposited layer thickness of this STO insulating layer **12** is in the range of 5 to 30nm. The Sr-to-Ti ratio x/y >1, preferably between (1/1)< x/y < (4/1).

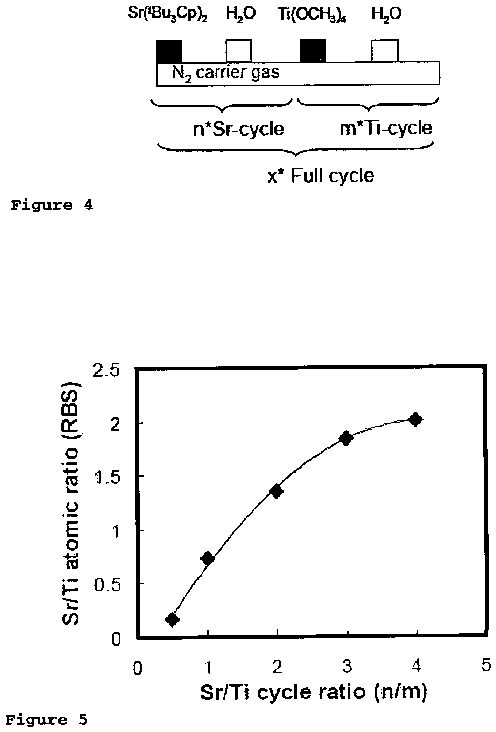

In a metal-insulator-metal capacitor **10** according to this disclosure, the insulating material **2** as deposited is a strontium-rich $Sr_xTi_yO_z$ material with x, y,z, being integers. With Sr-rich $Sr_xTi_yO_z$ is meant an oxide whereby the Sr-to-Ti ratio x/y is greater than the stoichiometric ratio, i.e. the Sr-to-Ti ratio x/y is greater than 1. Figure 5 illustrates examples of such non-stoichiometric $Sr_xTi_yO_z$ material.

In metal-insulator-metal capacitors **10** according to this disclosure $Sr_xTi_yO_z$ grains with a Sr content in excess of the stoichiometric ratio x/y=1 may be present in the insulating layer **12**. These Sr-rich grains may be distributed over the area of this layer **12** such that leakage paths between the top electrode **13** and the bottom electrode **11** are prevented or at least the number of such leakage paths is reduced compared to a stoichiometric $SrTiO_3$ insulating layer. As these Sr-rich grains may have a smaller diameter compared to a stoichiometric $Sr_xTi_yO_z$ insulating layer **12,** the non-stoichiometric layer of this disclosure may show less cracks.

In metal-insulator-metal capacitors **10** according to this disclosure the interface between the Ti-containing bottom electrode **11** and the $Sr_xTi_yO_z$ insulating layer **12** is essentially free from titanium-oxide such that the Ti-containing bottom electrode **11** is in direct physical contact with this insulating layer **12**. As titanium-oxide might be present in different crystal orientations on top of the Ti-containing bottom electrode, growing the $Sr_xTi_yO_z$ having the required properties on top of such titanium-oxide is cumbersome.

The $Sr_xTi_yO_z$ based insulating layer **12** of his MIM capacitor **10** is sandwiched between a bottom electrode **11** and a top electrode **13** as shown in figure 1. The insulator **12** of this MIM capacitor **10** comprises an oxide of strontium and titanium and the metal bottom electrode **11** consists of TiN. The metal top electrode **13** can be formed from Pt or other metals used in the art to form a top electrode for a MIM capacitor **10.**

In method according to the invention, this insulator **12** consists of an oxide of strontium and titanium and the metal bottom electrode **11** consists of TiN.

A method is disclosed for manufacturing $Sr_xTi_yO_3$ based Metal-Insulator-Metal (MIM) capacitors having an EOT of less than 0.5nm and a leakage current less than, preferably less than $5x10^{-7}$ A/cm$^2$.

The method comprises forming the insulating layer using a low temperature Atomic Layer Deposition (ALD) process. Preferably this ALD process employs an $Sr(t\text{-}Bu_3Cp)_2$ based precursor system. The ALD process is performed at temperatures less than 300°C, preferably 250 °C. This method further requires optimizing the ALD deposition variables, the insulator layer composition and the post-insulator layer deposition processing.

This manufacturing method allows the use of low-cost, manufacturable-friendly TiN bottom electrodes. By varying the Sr/Ti ratio in the $Sr_xTi_yO_z$ dielectric layer of the capacitor, the electric properties of the capacitor can be tuned as film crystallization temperature, its texture and morphology strongly depends on this ratio. The dielectric constant and the leakage current decrease monotonously with the Sr content in the Sr-enriched insulating layer **12**. The intercept of the EOT vs. physical thickness plot further indicates that increasing the Sr-content at the film interface with the bottom TiN would result in lower interfacial equivalent-oxide thickness (EOT).

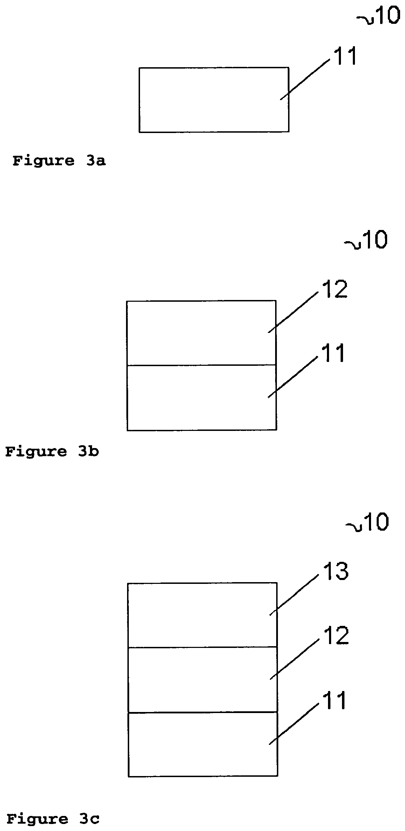

A method is disclosed, illustrated by figures 3a-c, for forming such a metal-insulator-metal capacitor **10** whereby the insulator **12** comprises an oxide of strontium and titanium and the metal bottom electrode **11** comprises Ti. The method comprises: forming a bottom electrode **11** comprising titanium (figure 3a), forming on the bottom electrode **11** an insulating layer **12** comprising an oxide of strontium and titanium (figure 3b), and forming on the insulating layer **12** a top electrode **13** whereby the top electrode **13** is electrically isolated from the bottom electrode **11** (figure 3c).

In a preferred embodiment a method is disclosed, illustrated by figures 3a-c, for forming such metal-insulator-metal capacitor **10** whereby the insulator **12** consists of an oxide of strontium and titanium and the metal bottom electrode **11** consists of TiN. The method comprises: forming a bottom electrode **11** consisting of TiN (figure 3a), forming on the bottom electrode **11** an insulating layer **12** consisting of an oxide of strontium and titanium (figure 3b), and forming on the insulating layer **12** a top electrode **13** whereby the top electrode **13** is electrically isolated from the bottom electrode **11** (figure 3c). The insulating layer **12** is in direct physical contact with the bottom electrode **11** and the top electrode **13** is in direct physical contact with the insulating layer **12**.

Prior to the step of forming the metal top electrode **13** a thermal step can be performed to crystallize the insulating layer **12**. In case of a Sr-rich $Sr_xTi_yO_z$ oxide a crystalline oxide can be obtained at temperatures below 600°c, even below 550°C, whereby the high-k perovskite crystalline phase is obtained. This crystallization step is preferably performed in a temperature range between 500°C and 600°C, more preferably in a temperature range between 530°C and 570°C, typically at a temperature of about 550°C.

The bottom electrode **11** consisting of TiN can be formed by Atomic Layer Deposition (ALD), by Metal-Organic Chemical Vapor Deposition (MOCVD), by Physical Vapor Deposition (PVD) or by other techniques known in the semiconductor process technology.

The insulating layer **12** is formed in a low-oxygen ambient, preferably a non-oxidizing ambient, such that the underlying Ti-containing bottom electrode **11** remains essentially oxide-free during the insulating layer forming process. This insulating layer **12** can be formed using Atomic Layer Deposition (ALD) with selected precursors allowing the formation of the insulating layer **12** at lower temperatures, i.e. between 200°C and 300°C and in a low oxygen or oxygen-free ambient. This precursor is preferably a $Sr(t\text{-}Bu_3Cp)_2$ based precursor system.

United States patent US 7,108,747 discloses an Atomic Layer Deposition (ALD) process for producing $SrTiO_3$ thin films. United States patent application US2006/0219157 also discloses an Atomic Layer Deposition (ALD) process for producing titanium containing oxide thin films.

The insulating material **12** as deposited is a strontium-rich $Sr_xTi_yO_z$ material with x, y,z, being integers. With

Sr-rich $Sr_xTi_yO_z$ is meant an oxide whereby the Sr-to-Ti ratio x/y is greater than the stoichiometric ratio, i.e. the Sr-to-Ti ratio x/y is greater than 1.

During the step of depositing the $Sr_xTi_yO_z$ insulating layer **12** the ratio Sr-to-Ti x/y can be kept higher than the stoichiometric ratio x/y=1. Optionally this Sr-to-Ti ratio x/y can be kept substantially equal to the stoichiometric ratio 1, while only during a part of the deposition process this Sr-to-Ti ratio x/y is set higher than the stoichiometric value 1.

In the invention, a method is disclosed for forming such metal-insulator-metal capacitor **10** whereby the insulator **12** consists of an oxide of strontium and titanium and the metal bottom electrode **11** consists of TiN. The method comprises: forming a bottom electrode **11** consisting of titanium nitride, forming on the bottom electrode **11** an insulating layer **12** consisting of an oxide of strontium and titanium, and forming on the insulating layer **12** a top electrode **13** whereby the top electrode **13** is electrically isolated from the bottom electrode **11**.

The metal-insulator-metal capacitor **10** according to this patent application shows an Electrical Equivalent Oxide Thickness (EOT) of less than 0.5nm while the leakage current through the insulating layer **12** is less than 500 nA/cm$^3$ when 1V is applied between the top **13** and bottom **11** electrode.

## Example 1

### Experimental details

STO layers were deposited by Atomic Layer Deposition (ALD) in a cross-flow ASM Pulsar® 2000 reactor, at reactor temperatures in the 250°C-300°C range. The precursors were Sr(t-Bu3Cp)2, H2O, and Ti(OCH3)4. In order to make a layer having a predetermined thickness the full cycle has to be repeated a number x*, while within each full cycle the number n* of Sr precursor pulses and the number m* of Ti precursor pulses can be selected in view of the desired Sr/Ti ratio within that full cycle as illustrated by figure 4. By changing the Sr-precursor and the Ti-precursor pulse sequence, ALD allows the growth of a wide compositional variety of STO films from pure TiO2 to Sr-rich, with straight forward composition tuning. Figure 2 shows the Sr/Ti atomic ratio x/y as determined by Rutherford Backscattering (RBS) as function of the Sr/Ti pulse cycle ratio n*/m* thereby referring to the sequence illustrated in figure 4. A pulse cycle ratio n*/m* of about 1.5 corresponds to a stoichiometric $SrTiO_3$ with x=y=1 and z=3.

In ALD, the STO growth is determined by self-limiting surface reactions, guaranteeing conformal deposition of STO in high aspect ratio structures which is required for advanced DRAM structures. STO films **12** in the 7-30 nm range were grown respectively on ALD TiN, MOCVD TiN or W bottom electrodes **11**. Three different Sr:Ti composition atomic ratios x/y were studied, a "standard composition" close to stoichimoetric atomic ratio (x/y~1), a Ti-rich composition (x/y~0.2) and a Sr-rich composition (x/y~1.5).

### Physical analysis

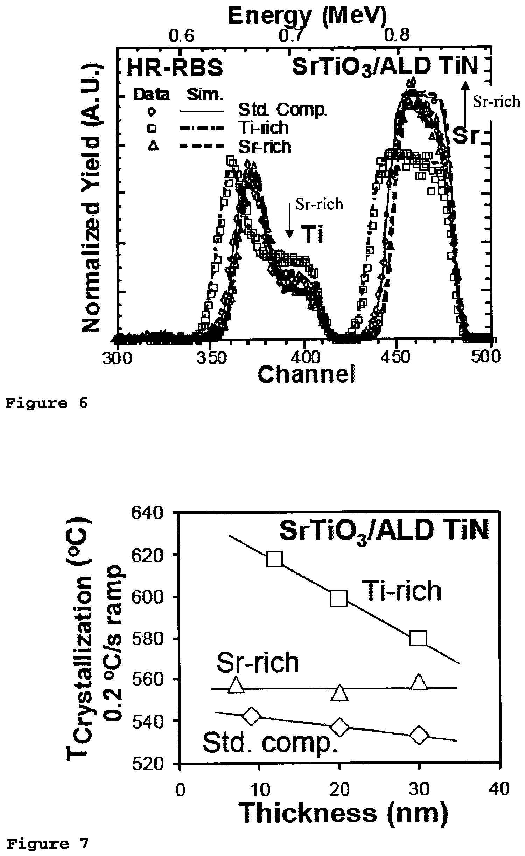

Figure 6 shows examples of high resolution Rutherford BackScattering (RBS) profiles of STO films **12** on a ALD TiN bottom electrode **11** for the three compositions: standard composition (Std Comp) (diamonds), Ti-rich (squares) and Sr-rich (triangles). As-deposited STO films were amorphous.

Careful characterization of the STO crystallization behavior of these three STO film **12** compositions was achieved by in-situ XRD measurement during ramp anneals in a He ambient whereby the film was annealed in the ALD chamber. All three film composition crystallized into the high-k perovskite STO phase at temperatures in the 540-620°C range. Crystallization of sub-10 nm Std. Comp. (x/y~1) and Sr-rich (x/y~0.2) films **12** after ex-situ 550°C 1 min anneal in N2 was also verified by cross-sectional TEM. Figure 7 shows the temperature of the 3 STO film **12** types, formed on an ALD TiN bottom electrode **11,** as function of the film thickness at which temperature the STO film crystallizes into the perovskite phase. The temperature was ramped at 0.2°C/sec. The crystallization temperature was higher for the Ti-rich films (x/y~0/2), especially for the thinner films.

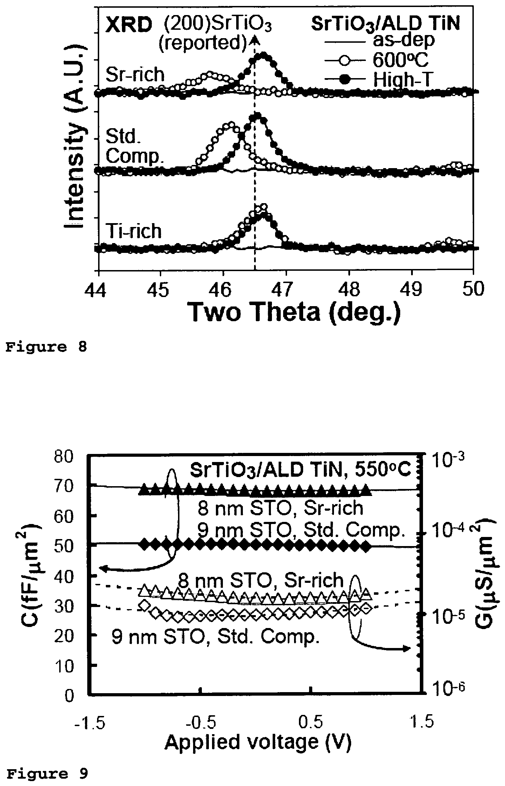

TEM analysis showed, in agreement, that 14 nm Ti-rich films were still mostly amorphous after 550°C anneal. STO peak-positions for Sr-rich films (x/y~1.5) after anneal to 600°C were found to be shifted respect to reported bulk, i.e. very thick STO layers, STO values, but reached the bulk values with higher T annealing. Figure 8 shows the XRD spectra of three STO film types deposited on ASD TiN bottom electrode **11**. The shift is clearly for the thicker Sr-rich STO film, with bulk STO values achieved above 800°C. This suggests Sr may be in solution in STO after low temperature crystallization anneals and expelled out of STO grains at higher temperatures. The RBS data in figure 6 suggests excess Sr may be preferentially close to the bottom TiN interface.

### Electrical evaluation

In order to perform an electrical evaluation of three STO film types, after annealing the insulating STO layer **12** into the crystalline perovskite phase, a PT top electrode **13** on the stack of the respective crystalline STO layer **12**/TiN bottom electrode **11**.

Figure 9 presents typical C-V, G-V curves measured on these STO **12**/ALD TiN **11** films, with the STO film **12** having either the standard composition (x/y~1) or the Sr-rich composition (x/y~1.5), after Rapid Thermal Anneal (RTA) at 550°C for 60sec in N2. Flat C-V characteristics with high capacitance densities are observed while conductance values remain low.

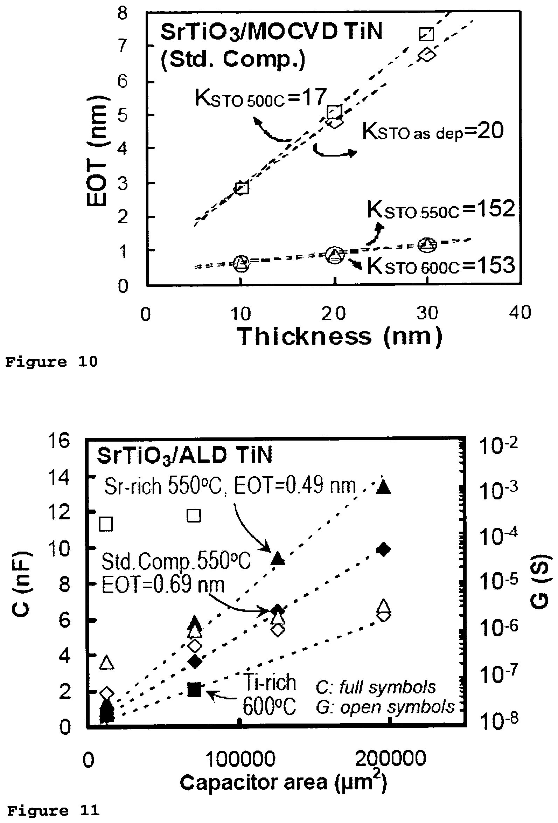

The impact of crystallization on the electrical properties of STO films on a MOCVD TiN bottom electrode **11** is clearly depicted in figure 10 showing the relationship between the EOT thickness (nm) and the physical thickness (nm) for a STO film **12** having the standard composition (Std. Comp.: x/y~1) as function of the crystallization anneal step: no anneal i.e. as deposited, anneal 500°C, anneal 550°C and anneal at 600°C. Typical K values obtained for crystalline STO films with Std. Comp. are -150. In agreement with the outcome of the in situ XRD measurements illustrated by figure 8, an anneal at 500°C is not sufficient to crystallize Std. Comp. STO films which will show a K value comparable to amorphous films (-20). Similar results were obtained for these STO films when an ALD TiN bottom electrode **12** was used.

Figure 11 shows that measured capacitance C and conductance G of annealed crystalline STO films **12** according to figure 5, sandwiched between an ALD TiN bottom electrode **11** and a Pt top electrode **13**. The Std Comp and Sr rich STO film were annealed at 550°C, while the Ti rich STO film was annealed at 600°C in line with the discussion above regarding figures 4 and 5. For each type of STO film **12,** the capacitance C scales linearly with the capacitor area. Extracted values for the EOT are as low as 0.49 nm for a 7.5 nm Sr-rich film (x/y ~1.5) and 0.69 nm for a 9 nm Std. Comp. film (x/y~1) while the conductance remains low, i.e. exhibiting a low leakage current.

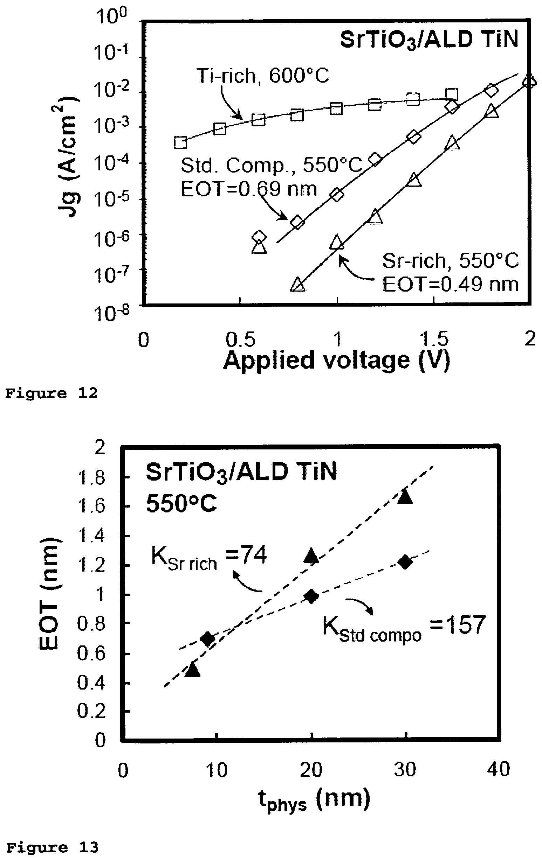

Figure 12 shows leakage current density Jg - voltage V characteristics for crystallized STO films, having one of the three compositions illustrated by figure 5, on a ALD TiN bottom electrode: standard composition (diamonds), Ti-rich (squares), Sr-rich (triangles). For the Ti-rich (x/y ~0.2) STO film it was difficult to extract the EOT due to the high conductivity/high leakage observed in those films as can be seen in figures 8 and 9.

Figure 13 further compares the electrical characteristics of crystallized STO films with standard (x/y~1) and Sr-rich (x/y ~1.5) compositions as shown in figure 5. A linear relationship between EOT and physical thicknesses is observed, from which K values can be extracted for both compositions. Sr-rich samples show lower K and lower leakage than Std. Comp. films. Despite lower K values, for thin films (tphys<10nm), lower EOTs can be achieved for Sr-rich films which is attributed to a better interface with the underlying TiN bottom electrode **11**.

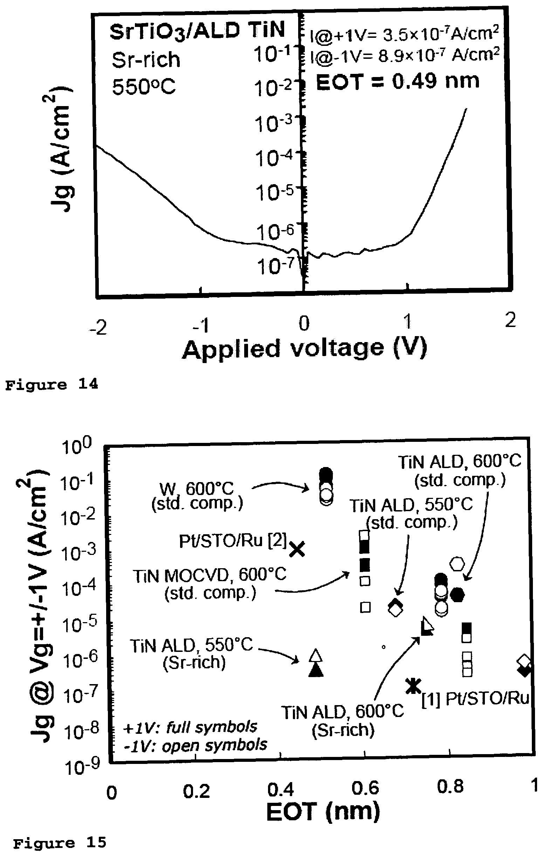

Typical leakage current density Jg-V behavior of a MIMcap device **10** composed of a Pt top electrode **13/** a crystallized Sr-rich STO insulating layer **12**/a TiN bottom electrode **11,** whereby the insulating layer had EOT of 0.49nm is presented in figure 14. An excellent low leakage behavior is observed, with $Jg(+1V)=3.5\times10^{-7}$ A/cm2 and $Jg(-1V)=8.9\times10^{-7}$ A/cm2 which are the lowest leakage values reported so far for STO with ~0.5nm EOT.

Conductive AFM measurements were performed to understand, at a microscopic scale, the leakage paths in the STO films. From these measurements it is concluded that the leakage conduction is through the bulk of grains and follows the topography whereby a higher topography corresponding to a higher leakage. If one compares the density of the leakage spots as obtained by these conductive AFM measurements (Vg=3.2V) of STO films (tphys<10nm) with Std. (x/y~1) and Sr-rich (x/y~1.5) compositions, one can see that the density of leakage spots is higher for the Std. Comp., in agreement with the I-V curves shown in figure 12.

Leakage density values at $\pm1V$ are presented as a function of EOT in figure 15 for crystallized Std. (x/y~1) and Sr-rich (x/y~1.5) STO films **12** deposited on TiN (ALD, MOCVD) and W bottom electrodes **11** and after different thermal treatments, showing improvement for films on TiN over recent published data on Ru. 550°C seems to be the optimal anneal temperature, since higher T increases EOT without leakage reduction and lower T results in non crystalline (lower-K) films. Sr-rich composition gives overall lower leakage and lower EOT for thin films than the Std. Comp.

## Example 2

### Experimental details

$Sr_xTi_yO_3$ layers were deposited by atomic layer deposition in a cross-flow ASM Pulsar® 3000 reactor on 300mm Si (100) substrates covered with either 1nm SiO2 or with 20nm SiO2/10nm ALD TiN, at reactor temperatures of 250°C. The precursors were $Sr(t-Bu_3Cp)_2$ and $Ti(OCH_3)_4$ using $H_2O$ as an oxidizer. The Sr and Ti sources were heated to 180°C and 160°C respectively to ensure a high enough dose for a saturated ALD process. The temperature of the $H_2O$ container was 15°C. The vapor pressure was set high enough the achieve STO deposition at temperatures below 300°C. By changing the Sr to Ti-precursor ratio, ALD allows the growth of a wide compositional variety of $Sr_xTi_yO_3$ films. The ALD process is done in one-step and does not require any seed layer optimization before deposition of the SrTiOx layer. $Sr_xTi_yO_3$ films in the 7-20 nm range were grown mainly on ALD TiN substrates. Different Sr:Ti pulse ratios n*/m* namely 1:1, 4:3, 3:2, 2:1, 3:1 and 4:1 were studied, resulting in different Sr:Ti composition ratios. In this exemplary embodiment composition is indicated by giving the pulse ratios.

The film thicknesses and densities were evaluated by x-ray reflectometry (XRR) while ellipsometry was used to check the uniformity over the wafer (KLA-Tencor ASET F5). The composition and contaminant levels of the films were investigated by means of (i) high resolution Rutherford Backscattering Spectrometry (HRRBS); (ii) Time-of-Flight Secondary Ion Mass Spectrometry TOFSIMS depth profiles using a ION-TOF IV instrument operating in the dual ion beam mode; and (iii) angle resolved x-ray photoelectron spectroscopy (ARXPS) measurements using a Thermo Theta300 instrument with monochromatized Al K$\alpha$ radiation (1486.6 eV). The $Sr_xTi_yO_3$ crystallization temperature and phase were studied by *in situ* x-ray diffraction while the film roughness and microstructure were assessed by atomic force microscopy (AFM) using a Veeco Dimension 3100 instrument and by transmission electron microscopy (TEM) using a Tecnai F30 at 300kV. The STO crystallization anneal, when applied, was performed by rapid thermal annealing (RTA) before the top electrode deposition using a Heat-Pulse system with controlled atmosphere ambient. Electrical measurements were performed using Pt top electrodes (diameters 100-500$\mu$m) deposited by e-beam evaporation through a shadow mask using a Pfeiffer PLS 580 tool. C-V, G-V characteristics were measured with an Agilent 4284A LCR meter while I-V measurements were carried out using a Keithley 2602 multimeter. The Keithley 2602 has a limited current accuracy of $\sim$ 10 pA, but allows for fast, automated screening of samples. To better understand the conduction mechanisms in those films, macroscopic electrical characterizations were complemented by microscopic conductive AFM (C-AFM) measurements. The Veeco Dimension 3100 instrument was converted from AFM to CAFM simply by (i) changing the tips for contact mode imaging by tips with Pt/Ir coating (20-30nm) for electrical measurements and (ii) replacing the sense amplifier. Finally, the optical band gaps of $Sr_xTi_yO_3$ with various Sr-contents were measured by spectroscopic ellipsometry using a Sopra GES 5 Optical platform with spectral range from 800 to 190nm.

A first-principles Density Functional Theory (DFT) linear response approach was used to calculate the dielectric constants and band gap of a series of $Sr_xTi_yO_3$ compositions (from stoichiometric to strontium rich): SrTiO3, $Sr_2TiO_4$, $Sr_3Ti_2O_7$ and $Sr_4Ti_3O_{10}$.

## Physical analysis

### - thickness and uniformity.

The $Sr_xTi_yO_3$ thickness uniformity measured by ellipsometry over 300 mm wafers indicated a within wafer thickness non-uniformity $\leq$ 2.5%. In addition, the STO film thicknesses and densities were measured using XRR on representative samples before and after crystallization anneals. Typical thickness contraction was about 10% after an anneal of 600°C in $N_2$ for 1min, the film density increasing from $\sim$85% to $\sim$95% of the bulk value (5.12 g/cm$^3$).

### - composition and contamination analysis

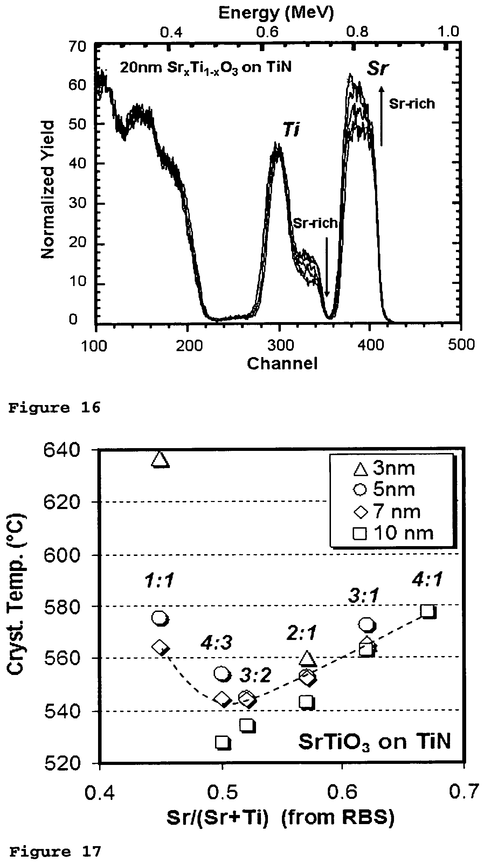

Figure 16 presents the Sr and Ti HRRBS depth profiles of as deposited 20nm thick $Sr_xTi_yO_3$ films with Sr:Ti ALD pulse ratios ranging from 4:3 (stoichiometric) to 4:1 (67% Sr) . As expected, the Sr and Ti signals were found to be dependent upon the Sr:Ti pulse ratio, the Sr (respectively Ti) signal increasing (respectively decreasing) with increasing the Sr:Ti pulse ratio. The extracted film compositions are presented in table 1 below as a function of the ALD Sr:Ti pulse ratios.

Table 1: ALD Sr:Ti pulse ratios and corresponding compositions (atomic %) measured by High Resolution Rutherford Backscattering Spectrometry (HRRBS)

| ALD Pulse ratio (Sr:Ti) | Sr/(Sr+Ti) (at. %) from HRRBS |
|---|---|
| 1:1 | 45 |
| 4:3 | 50 |
| 3:2 | 52 |
| 2:1 | 57 |
| 3:1 | 62 |
| 4:1 | 67 |

The composition (Sr:Ti ratio) uniformity over the wafer was excellent (<1.4%). Furthermore, the composition was proven not to be affected (within experimental error $\sim$ 2%) by a change in the underlying substrate nor by an anneal at 600°C (for lmin in $N_2$ atmosphere). TOFSIMS profiles indicated low C, F and Cl contamination in the bulk of the films. The C contaminant level measured by XPS was below the detection limits (<1%). The characterization of the $Sr_xTi_yO_3$ films was further completed by ARXPS measurements, showing the presence of $SrCO_3$ on the film surface. For as deposited films, the $SrCO_3$ concentration was found to increase with increasing Sr:Ti ALD pulse ratios. This $SrCO_3$

concentration can be strongly reduced by a thermal treatment at 600°C for lmin in $N_2$.

**- crystallization behavior**

The crystallization behavior of the $Sr_xTi_yO_3$ films was assessed by in-situ XRD ($\theta$-2$\theta$ geometry) during ramp anneals (0.2°C/s) in $N_2$. As-deposited $Sr_xTi_yO_3$ films are amorphous and crystallize into the perovskite STO phase at temperatures in the 520-640°C range. The crystallization temperature strongly depends on film composition and thickness as show in figure 17. Stoichiometric $SrTiO_3$ ([Sr/(Sr+Ti)]~0.5) shows the lowest crystallization temperature for a given thickness. As expected, thinner films require a higher temperature to crystallize but the impact of thickness on crystallization temperature seems more pronounced when increasing the Ti-content.

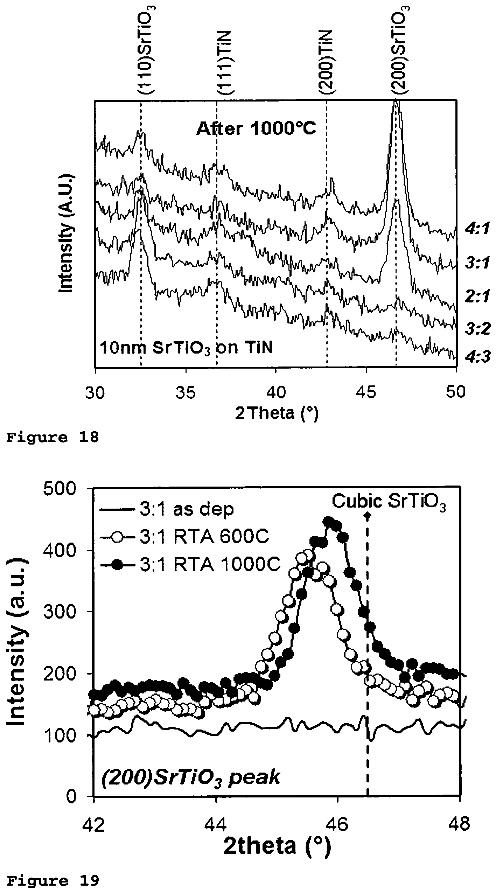

In-situ XRD reveals two other noticeable features regarding the impact of composition on the crystallization behavior of $Sr_xTi_yO_3$ films. While all films crystallize into the perovskite structure, the relative intensities of the $Sr_xTi_yO_3$ Bragg peaks change drastically with composition. To better illustrate that point, $\theta$-2$\theta$ scans were taken after the complete ramp anneal as shown in figure 18. Stoichiometric $SrTiO_3$ films deposited on TiN exhibit a XRD pattern close to the one reported for bulk polycrystalline $SrTiO_3$ films. The addition of strontium induces a change in the texture of the films; Sr-rich films being more (200) oriented. This effect is strongly related to the underlying layer as no drastic texture change was observed when depositing $SrTiO_3$ with the same processing parameters directly on Si.

The second observation relies on the fact that the STO peak positions after anneal at 600°C were found to be shifted with respect to the reported bulk perovskite STO values, but approach the bulk values with higher annealing temperature. This effect is present especially for Sr-rich films as shown in figure 19 (10 nm 3:1 film). This suggests the excess Sr may be in solution in STO after low crystallization temperature anneals and expelled out of STO grains at higher temperature.

To support this assumption, SEM plan view images were taken on 10nm stoichiometric (4:3) and Sr-rich (3:1) films annealed at various temperatures. Stoichiometric films are amorphous for annealing temperature up to 525°C. In agreement with IS-XRD, crystalline features, namely $SrTiO_3$ grains and star-shaped patterns, can be observed at 600°C. The appearance of the star-shaped patterns in the layers has been attributed by TEM analyzes to stress in the layer After crystallization anneal at 700°C for lmin in $N_2$, cracks appear on the film surface of stoichiometric $SrTiO_3$ films. On the other hand, when annealed at 700°C for lmin in $N_2$, Sr-rich films exhibit the formation of large Sr-rich crystals. At 600°C, Sr-rich films are crystalline (grain size ~40nm) as can been seen in the TEM cross sections and in agreement with IS-XRD results but there is no formation of Sr-rich crystals. At 550°C the Sr-rich STO films are still amorphous. These SEM observations are in good agreement with a scenario involving the presence of excess Sr in solution at low crystallization annealing temperatures and segregation out of the $SrTiO_3$ grains at higher temperatures.

**Electrical evaluation**

**- As-deposited $Sr_xTi_yO_3$ films**

The electrical properties of as-deposited $Sr_xTi_yO_3$ based capacitors are summarized in figures 17 and 18.

Figure 20 shows the EOT evolution of as-deposited films with various Sr:Ti ratios as a function of their physical thickness. Two main conclusions can be drawn based on these results. For all compositions, the EOT varies linearly with the film thickness. Moreover the slope is rather similar for all compositions suggesting that the intrinsic ('bulk") dielectric constant of the amorphous layers is only slightly affected by changes in the film composition. The extracted relative dielectric K values range from 16 to 18. On the other hand, for every given thickness, the EOT value increases systematically with increasing Sr-content. This indicates that the interface between $Sr_xTi_yO_3$ layers and the electrodes is sensitive to the film composition. It is believed that the $SrCO_3$ layers observed on the film surfaces might be responsible of that EOT penalty; the $SrCO_3$ amount increasing with the Sr-content.

Figure 18 shows the leakage current density Jg-V curves of 16 nm as deposited $Sr_xTi_yO_3$ films with various Sr-contents. Surprisingly, the increase in EOT observed for Sr-rich films is linked with an increase in the leakage current. This observation suggests differences in the barrier height between the $Sr_xTi_yO_3$ film and the electrodes potentially due to the various $SrCO_3$ amounts observed in the films.

**- crystalline $Sr_xTi_yO_3$ films: influence of the composition on EOT and k**

Figure 19 shows the capacitance (measured at 0V, 1kHz) as a function of capacitor size for crystalline $Sr_xTi_yO_3$ films (annealed at 600°C for lmin in $N_2$) with compositions (Sr/(Sr+Ti)) ranging from 45% to 62%. For all compositions, the measured capacitance scales linearly with area (while the conductance remains <10$\mu$S for all capacitor sizes). Furthermore, Sr-enrichment of the $Sr_xTi_yO_3$ films results systematically (for a given capacitor size) in lower capacitance.

Figure 23 further compares the electrical characteristics of a MIM capacitor having a stack of a Pt top electrode

13/a $Sr_xTi_yO_3$ insulating layer **12** /a TiN bottom electrode **13** capacitors with various ALD pulse ratios and thicknesses after crystallization anneal at 600°C. As already seen in figure 21 a linear relationship between EOT and physical thickness is observed. Nevertheless, in contrast with as-deposited films, the Sr-content has a significant impact on the proportionality factors between EOT and physical thicknesses.

The extracted relative dielectric constant K values are presented in figure 24a as a function of $Sr_xTi_yO_3$ composition. The dielectric constant decreases monotonously with increasing Sr-content (K~210 for stoichiometric 4:3 films and K~56 for Sr-rich 3:1 films). The decrease in K value with increasing Sr content observed experimentally is in qualitative agreement with the trend predicted by ab-initio modeling for the ideal Ruddlesden-Popper phases. Furthermore, the extrapolation of EOT to zero $t_{phys}$ shown on figure 24b would suggest a decrease of interfacial EOT with increasing Sr-content. These extrapolations should be regarded with caution considering possible sources of fluctuations in the EOT extractions. Nevertheless, as already shown on figure 18, the texture of the $Sr_xTi_yO_3$ films was proven to vary with the Sr-content. This texture change should not affect drastically the dielectric properties of the bulk $Sr_xTi_yO_3$, considering that $Sr_xTi_yO_3$ has a cubic symmetry, but might corroborate the lower interfacial EOT extrapolated for Sr-rich films.

## - Crystalline $Sr_xTi_yO_3$ films: influence of the composition on the leakage properties

The leakage properties of 16 nm crystalline $Sr_xTi_yO_3$ films with the different compositions of interest are depicted in figure 25. For the same physical thickness, it is clear that Sr-rich films show a much lower leakage current. To better understand this phenomenon, two factors were considered.

The "intrinsic" modification of the $Sr_xTi_yO_3$ band gap as a function of the Sr:Ti ratio was evaluated by means of spectroscopic ellipsometry (for 20nm $Sr_xTi_yO_3$ films deposited on $SiO_2$ and annealed at 600°C for lmin in $N_2$). The extracted optical band gaps increase (from 3.7eV to 4eV) with increasing Sr-content (from stoichiometric 3:2 to Sr-rich 4:1) suggests a higher band offset between the high-K STO layer and the electrodes, resulting in lower leakage currents for Sr-rich films. Note that the increase of the band gap with increasing Sr-content is also predicted by ab-initio calculations considering that the excess strontium is accommodated in the structure by formation of RP phases.

To look at possible "extrinsic" factors which could further explain the lower leakages observed for Sr-rich films, conductive AFM measurements were carried out on Ti-rich (1:1 ALD pulse ratio) and Sr-rich (3:1 ALD pulse ratio) films after crystallization anneal at 600°C for 1 in $N_2$. Ti-rich films show non-uniform distribution of the leakage spots. The clustering of leakage paths becomes more apparent with increasing the Ti-rich $SrTiO_3$ film thickness from 10nm to 15nm. Low leakage areas of ~220-250nm diameter are surrounded by a 2-dimensional network of leakage paths. Similar behavior has been observed on stoichiometric $SrTiO_3$ films. Knowing that the films were all crystalline, the leakage non-uniformity may be attributed either to higher leakage at grain boundaries due to segregation of Sr or Ti for instance, or by micro-cracks in the films. Most likely the second scenario is at the origin of the observed patterns for the following reasons: *(i)* CAFM investigations have shown that the leakage occurs predominantly in the bulk of the grains and not at grain boundaries; *(ii)* clear cracks have been seen present after annealing at 700°C for stoichiometric films as also observed in Ti-rich films. On the other hand, quite uniform distributions of leakage spots were demonstrated for Sr-rich films suggesting no obvious formation of cracks in these films. The films are very smooth (RMS roughness ~0.17nm). This is in total agreement with the observations made by SEM.

The experimental results systematic study of physical and electrical characterization of $Sr_xTi_yO_3$ thin films **11** deposited on TiN bottom electrode **12** by ALD with various Sr:Ti pulse n*/m* ratios (namely 1:1, 4:3, 3:2, 2:1, 3:1 and 4:1). Several conclusions can be drawn:

*(i)* The deposition process has been shown to be well controlled in terms of composition and thickness uniformity.
*(ii)* Careful composition analysis of the films was done by HRRBS, TOFSIMS and ARXPS. Despite the overall good control of the composition and low levels of bulk contaminants, ARXPS have also shown the presence of $SrCO_3$ at the $Sr_xTi_yO_3$ film surface. The amount of $SrCO_3$ increases with the Sr-content for as deposited films and can be significantly reduced by crystallization anneal.
*(iii)* The impact of Sr-content and thickness upon the $Sr_xTi_yO_3$ film crystallization was studied by *in situ* XRD. The crystallization temperature of stoichiometric films (Sr:Ti = 4:3 or 3:2) has been shown to be lower than for the other $Sr_xTi_yO_3$ compositions. Furthermore, *in situ* XRD measurements have shown a change in the film texture with increasing Sr content. Also, the diffraction peaks corresponding to Sr-rich $Sr_xTi_yO_3$ films annealed at 600 °C appear at lower angles than the state-of-the-art peak positions of bulk $SrTiO_3$ perovskites. Even if the mechanisms underlying the accommodation of excess Sr by the $Sr_xTi_yO_3$ structure remains unclear, Sr may be in solution in $Sr_xTi_yO_3$ after low temperature crystallization anneals and expelled out of $SrTiO_3$ grains at higher temperatures to form Sr-rich grains.
*(iv)* Clear tradeoff between low EOT and low leakage was observed for crystalline films. In the range of studied thicknesses, Sr-rich films show higher EOT (lower K) values and lower leakage current than stoichiometric or Ti-rich films but extrapolation to zero physical thicknesses would suggest lower interfacial EOT for Sr-rich composition.

The EOT and leakage dependence upon Sr-content, predicted by ab-initio modeling, were supported by electrical evidences and also by optical band-gap extractions by spectroscopic ellipsometry. C-AFM investigation suggests that the leakage increase observed for Ti-rich films might also originate from microcracks formation in the film possibly due higher stress in the layer.

The conclude, the above experimental observations show that the physical and electrical properties of $Sr_xTi_yO_3$ are extremely sensitive to the Sr:Ti ratio and prove that a careful choice of the composition is necessary for a targeted device application.

In the previous paragraphs and embodiments a MIMcap device **10** and methods for manufacturing MIMcap device **10** were disclosed having a non-stoichiometric $Sr_xTi_yO_3$ insulating layer **12** sandwiched between a bottom electrode **11,** comprising Ti, and a top electrode **13.** The non-stoichiometric $Sr_xTi_yO_3$ insulating layer **12** has a Sr-to-Ti atomic ratio x/y>1 and is Sr rich.

**Claims**

**1.**  (renumbered and amended)
A method for manufacturing a metal-insulator-metal capacitor (10), the method comprising;
forming a bottom electrode (11),
forming an insulating layer (12) on the bottom electrode (11), and forming a top electrode (13) on the insulating layer (12),
wherein
the insulating layer (12) is a $Sr_xTi_yO_z$ oxide, with x, y, z being integers and (x/y) > (1/1);
the insulating layer (12) is formed by Atomic Layer Deposition at a temperature below 300 degrees Celsius directly on the bottom electrode (11) and having an as-deposited thickness between 5 and 30nm, and
the bottom electrode (11) consists of TiN and the method further comprises:performing a anneal step at a temperature below 600 degrees Celsius on the as-formed insulating layer (12) thereby bringing the insulating layer into the crystalline perovskite phase so that the metal-insulator-capacitor has an equivalent oxide thickness (EOT) of 0.5nm or less and a leakage current of less than $5 \times 10^{-7}$ A/cm$^2$.

**2.**  (renumbered and amended)
The method of claim 1, wherein:
the insulating layer is a $Sr_xTi_yO_3$ oxide.

**3.**  (renumbered)
The method of any of the claims 1 or 2, wherein:

$$(1/1) < (x/y) \ < (4/1).$$

**Patentansprüche**

**1.**  Verfahren zum Herstellen eines Metall-Isolator-Metall-Kondensators (10), wobei das Verfahren umfasst:

Bilden einer unteren Elektrode (11),
Bilden einer Isolierschicht (12) auf der unteren Elektrode (11), und Bilden einer oberen Elektrode (13) auf der Isolierschicht (12),
wobei
die Isolierschicht (12) ein $Sr_xTi_yO_z$-Oxid ist, wobei x, y, z ganze Zahlen sind und (x/y) > (1/1),
die Isolierschicht (12) durch Atomlagenabscheidung bei einer Temperatur von unter 300 Grad Celsius direkt auf der unteren Elektrode (11) gebildet wird und eine abgelagerte Dicke zwischen 5 und 30 nm hat, und
die untere Elektrode (11) aus TiN besteht und das Verfahren weiterhin umfasst: Durchführen eines Glühschritts bei einer Temperatur von unter 600 Grad Celsius auf der gebildeten Isolierschicht (12), wodurch die Isolierschicht in die kristalline Perowskitphase gebracht wird, sodass der Metall-Isolator-Kondensator eine gleichwertige Oxidschichtdicke (EOT) von 0,5 nm oder weniger und einen Reststrom von weniger als $5 \times 10^{-7}$ A/cm$^2$ hat.

**2.**  Verfahren nach Anspruch 1, wobei:

die Isolierschicht ein $Sr_xTi_yO_3$-Oxid ist.

3. Verfahren nach einem der Ansprüche 1 oder 2, wobei:

$$(1/1) < (x/y) < (4/1).$$

**Revendications**

1. Procédé pour fabriquer un condensateur métal-isolant-métal (10), le procédé comprenant ;
   la formation d'une électrode inférieure (11),
   la formation d'une couche isolante (12) sur l'électrode inférieure (11), et
   la formation d'une électrode supérieure (13) sur la couche isolante (12),
   dans lequel
   la couche isolante (12) est un oxyde $Sr_xTi_yO_z$, x, y, z étant des nombres entiers et (x/y) > (1/1) ;
   la couche isolante (12) est formée par dépôt de couche atomique à une température inférieure à 300 degrés Celsius directement sur l'électrode inférieure (11) et ayant une épaisseur telle que déposée entre 5 et 30 nm, et
   l'électrode inférieure (11) consiste en TiN et le procédé comprend en outre : la mise en oeuvre d'une étape de recuit à une température inférieure à 600 degrés Celsius sur la couche isolante (12) telle que formée pour ainsi amener la couche isolante dans la phase pérovskite cristalline de façon que le condensateur métal-isolant présente une épaisseur d'oxyde équivalente (EOT) de 0,5 nm ou moins et un courant de fuite de moins de 5 x $10^{-7}$ A/cm$^2$.

2. Procédé selon la revendication 1, dans lequel :
   la couche isolante est un oxyde $Sr_xTi_yO_3$.

3. Procédé selon l'une quelconque des revendications 1 ou 2, dans lequel :

$$(1/1) < (x/y) < (4/1).$$

IMEC REF 2008/142_EPreg1

~10

13

12

11

**Figure 1**

~1

30

20

10

GND

40

**Figure 2**

~10

11

**Figure 3a**

~10

12

11

**Figure 3b**

~10

13

12

11

**Figure 3c**

Figure 4

Figure 5

Figure 6

Figure 7

Figure 8

Figure 9

Figure 10

Figure 11

Figure 12

Figure 13

Figure 14

Figure 15

**Figure 16**

**Figure 17**

**Figure 18**

**Figure 19**

Figure 20

Figure 21

Figure 22

Figure 23

Figure 24(a)

Figure 24(b)

Figure 25

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7108747 B
- US 20060219157 A
- US 20060214205 A

### Non-patent literature cited in the description

- *Journal Of electrochemical Society,* 2007, vol. 154 (6), G127-G133
- **J. HAENI et al.** Epitaxial growth of the first five members of the Srn+1TinO3n+1 Ruddlesden-Popper homologous series. *APPLIED PHYSICS LETTERS,* 21 May 2001, vol. 78, 3292-3294